# EUROPÄISCHE PATENTSCHRIFT

(11) **EP 3 167 481 B1**
(45) Veröffentlichungstag und Bekanntmachung des Hinweises auf die Patenterteilung: **25.11.2020**
(21) Anmeldenummer: 15729156.8
(22) Anmeldetag: 15.06.2015
(51) Int. Cl.: H01L 23/485, H01L 21/48

(54) **VERFAHREN ZUM HERSTELLEN EINES SUBSTRATADAPTERS, UND ZUM KONTAKTIEREN EINES HALBLEITERELEMENTS**
METHOD FOR PRODUCING A SUBSTRATE ADAPTER AND FOR CONTACTING A SEMICONDUCTOR ELEMENT
PROCÉDÉ DE PRODUCTION D'UN ADAPTATEUR DE SUBSTRAT, ET D'INTERCONNEXION D'UN ÉLÉMENT SEMI-CONDUCTEUR

(30) Priorität: 11.07.2014 DE 102014109766
(43) Veröffentlichungstag der Anmeldung: 17.05.2017
(73) Patentinhaber: Heraeus Deutschland GmbH & Co. KG, 63450 Hanau (DE)
(72) Erfinder: WIESELER, Elisa, 63768 Hösbach (DE); KRÜGER, Frank, 61130 Nidderau (DE); BLEIFUSS, Martin, 63796 Kahl (DE); SCHÄFER, Michael, 36093 Künzell (DE); HINRICH, Andreas, 63579 Freigericht (DE); KLEIN, Andreas Steffen, 63579 Freigericht (DE); BACHMANN, Christian, 6430 Nordborg (DK); ULRICH, Holger, 6430 Nordborg (DK); OSTERWALD, Frank, 6430 Nordborg (DK); BENNING, David, 6430 Nordborg (DK); RUDZKI, Jacek, 6430 Nordborg (DK); PAULSEN, Lars, 6430 Nordborg (DK); SCHEFUSS, Frank, 6430 Nordborg (DK); BECKER, Martin, 6430 Nordborg (DK)
(74) Vertreter: Kilchert, Jochen
(86) Internationale Anmeldenummer: PCT/EP2015/063256
(87) Internationale Veröffentlichungsnummer: WO 2016/005146

(56) Entgegenhaltungen:
- EP-A2- 1 772 900
- EP-A2- 2 498 283
- WO-A2-2013/045364
- DE-A1-102009 018 541
- JP-A- 2008 251 824

## Beschreibung

Die Erfindung betrifft ein Verfahren zum Herstellen eines Substratadapters, der insbesondere zum Kontaktieren eines Halbleiterelements dient. Daneben betrifft die Erfindung ein Verfahren zum Kontaktieren eines Halbleiterelements, insbesondere Leistungsbauelements, bei dem ein solcher Substratadapter zum Einsatz kommt.

Steigende Anforderungen in Leistungselektronik-Modulen, die beispielsweise die Leitfähigkeiten und die Lebensdauern betreffen, erfordern den Einsatz von Cu-Bonddrähten zur Kontaktierung von Leistungshalbleitern untereinander oder anderen Anschlüssen innerhalb eines Leistungselektronik-Moduls. Als Chipmetallisierung wird derzeit überwiegend ausschließlich eine Aluminiumbeschichtung bzw. Aluminiummetallisierung angeboten, wobei dies zu Problemen im Kontaktierungsprozess und in der späteren Anwendung führt. Beispielsweise kann es aufgrund einer derartigen Metallisierung zu späteren Ausfällen im Betrieb kommen.

Es existieren verschiedene Lösungsansätze zur Steigerung der Systemlebensdauer, so z. B. die Verwendung von sogenannten Flex-Leiterplatten. Allerdings sind auch derartige Flex-Leiterplatten mit einem Nachteil verbunden, da diese nicht mit einem konventionellen Draht-Bond-Prozess kontaktiert werden können, so dass bestehende Produktionskapazitäten nicht mehr genutzt werden können.

Aus EP 2 498 283 A2 ist ein indirektes Aufdrucken eines Kontaktierungsmaterials auf ein Metallelement bekannt. Auch in JP 2008 251824 A ist ein indirektes Beschichten bzw. Drucken offenbart.

In WO 2013/045364 A2 wird eine Trägerfolie offenbart, auf der mehrere Abschnitte mit einer sinterbaren Schicht angeordnet sind. Auf den sinterbaren Schichten sind wiederum Lotschichten aufgebracht.

Die Aufgabe der vorliegenden Erfindung ist es, eine, insbesondere hinsichtlich der Zuverlässigkeit der hergestellten Halbleitereinrichtungen, insbesondere Leistungshalbleitereinrichtungen, verbesserte Lösung bereitzustellen.

Erfindungsgemäß wird diese Aufgabe im Hinblick auf ein Verfahren zum Herstellen eines Substratadapters, der insbesondere zum Kontaktieren von Halbleiterelementen dient, durch ein Verfahren mit den Merkmalen des Patentanspruches 1 oder des Patentanspruches 2 und im Hinblick auf das Verfahren zum Kontaktieren eines Halbleiterelements, insbesondere Leistungsbauelements, mittels eines erfindungsgemäßen Substratadapters durch ein Verfahren mit den Merkmalen des Patentanspruches 14 oder 15 gelöst.

Vorteilhafte und zweckmäßige Ausgestaltungen des erfindungsgemäßen Verfahrens zum Herstellen eines Substratadapters bzw. des erfindungsgemäßen Verfahrens zum Kontaktieren eines Halbleiterelements, insbesondere Leistungsbauelements, mittels eines erfindungsgemäßen Substratadapters sind in den Unteransprüchen angegeben.

Das erfindungsgemäße Verfahren zum Herstellen eines Substratadapters, der insbesondere zum Kontaktieren von Halbleiterelementen dient, umfasst die Schritte:
- Aufbringen eines Kontaktierungsmaterials auf eine Seite eines Trägers,
- Strukturieren eines elektrisch leitenden Metallelements,
- Positionieren des strukturierten Metallelements auf dem Träger derart, dass eine erste Seite des Metallelements und die mit dem Kontaktierungsmaterial versehene Seite des Trägers gegenüber angeordnet sind,
- Fügen des strukturierten Metallelements mit dem mit Kontaktierungsmaterial versehenen Träger,
- Aufbringen eines Transferelements auf eine zweite Seite des strukturierten Metallelements,
- Vereinzeln des Transferelements und/oder des strukturierten und mit Kontaktierungsmaterial zusammengefügten Metallelements zur weiteren Verarbeitung.
In einem weiteren Aspekt umfasst das erfindungsgemäße Verfahren zum Herstellen eines Substratadapters, der insbesondere zum Kontaktieren von Halbleiterelementen dient, die Schritte:
- Aufbringen eines Kontaktierungsmaterials auf eine Seite eines Trägers,
- Strukturieren eines elektrisch leitenden Metallelements,
- Positionieren des strukturierten Metallelements auf dem Träger derart, dass eine erste Seite des Metallelements und die mit dem Kontaktierungsmaterial versehene Seite des Trägers gegenüber angeordnet sind,
- Fügen des strukturierten Metallelements mit dem mit Kontaktierungsmaterial versehenen Träger,
- Vereinzeln des strukturierten und mit Kontaktierungsmaterial zusammengefügten Metallelements zur weiteren Verarbeitung.

Das erfindungsgemäße Verfahren kann demnach optional den Schritt umfassen, dass auf eine zweite Seite des strukturierten Metallelements ein Transferelement aufgebracht wird.

Das Aufbringen des Kontaktierungsmaterials kann auch als Transferieren bezeichnet werden. Des Weiteren ist es möglich, dass das Kontaktierungsmaterial als Kontaktierungslage auf eine Seite des Trägers aufgebracht bzw. transferiert wird.

Das Strukturieren eines elektrisch leitenden Metallelements betrifft das Einarbeiten von Strukturen in ein elektrisch leitendes Metallelement, wobei die Strukturen sowohl auf einer als auch auf mehreren Seiten eines elektrisch leitenden Metallelementes eingearbeitet werden können. Vorzugsweise erfolgt das Strukturieren eines elektrisch leitenden Metallelements im Hinblick auf die zu erlangende Form eines Substratadapters bzw. die zu erlangende Form eines Kontaktierungsmittels. Beispielsweise ist es möglich, dass in ein elektrisch leitendes Metallelement in Abstand zueinander gleichartige bzw. übereinstimmende Formen eingearbeitet werden.

Bei dem mit einem Kontaktierungsmaterial versehenen Träger und dem strukturierten elektrisch leitenden Metallelement handelt es sich hiernach zunächst um zwei voneinander getrennt zu bearbeitende bzw. bearbeitbare Elemente, die anschließend zueinander positioniert werden. Die Positionierung des strukturierten Metallelements auf dem Träger erfolgt derart, dass die erste Seite des Metallelements und die mit dem Kontaktierungsmaterial versehene Seite des Trägers gegenüberliegend angeordnet sind. Mit anderen Worten weisen die erste Seite des Metallelements und die mit dem Kontaktierungsmaterial versehene Seite des Trägers bzw. das Kontaktierungsmaterial und die erste Seite des Metallelements zueinander. Nach der vorzugsweise passgenauen Positionierung des strukturierten Metallelements in Relation zu dem Träger erfolgt ein Fügen des strukturierten Metallelements mit dem mit Kontaktierungsmaterial versehenen Träger. Mit anderen Worten werden der Träger und das strukturierte Metallelement zusammengefügt, wobei das Kontaktierungsmaterial beim bzw. nach dem Zusammenfügen das strukturierte Metallelement auf der ersten Seite berührt.

Nach der Bildung des ersten Zwischenelements, nämlich dem mit dem Träger zusammengefügten strukturierten Metallelement, kann auf die zweite Seite des strukturierten Metallelements, auf dem vorzugsweise kein Kontaktierungsmaterial vorgesehen ist, ein Transferelement aufgebracht werden. Mit anderen Worten befinden sich auf einer Seite des strukturierten Metallelements das Kontaktierungsmaterial und der Träger. Auf der anderen Seite bzw. gegenüberliegenden Seite des strukturierten Metallelements befindet sich das Transferelement.

Das Vereinzeln des Transferelements und/oder der des strukturierten und mit Kontaktierungsmaterial zusammengefügten Metallelements zur weiteren Verarbeitung betrifft das Herausarbeiten bzw. das zur Verfügung stellen von einzelnen Substratadaptern. Demnach ist es theoretisch möglich, dass ein Substratadapter wahlweise ein Transferelement umfasst oder nicht.

In diesem Zusammenhang sei darauf hingewiesen, dass als Substratadapter sowohl ein einzelner Substratadapter als auch eine Vielzahl von auf einem Träger angeordneten Substratadapter zu verstehen ist. Demnach betrifft das erfindungsgemäße Verfahren sowohl ein Verfahren zum Herstellen eines Substratadapters als auch ein Verfahren zum Herstellen einer Anordnung mehrerer Substratadapter auf einem Träger.

Mit Hilfe des Vereinzelns des Transferelements und/oder des strukturierten und mit Kontaktierungsmaterial zusammengefügten Metallelements können die Formen des Substratadapters bzw. die Formen der nebeneinander auf einem Träger angeordneten Substratadapter hergestellt werden. Beispielsweise bilden das Transferelement bzw. die durch Vereinzelung eines Transferelements hergestellten Transferelementabschnitte, das strukturierte und mit Kontaktierungsmaterial zusammengefügte und optional vereinzelte Metallelement Substratadapter bzw. mehrere Substratadapter, die auf dem vorzugsweise nicht zu vereinzelnden Träger angeordnet sind. Des Weiteren ist es denkbar, dass lediglich das mit Kontaktierungsmaterial zusammengefügte, vereinzelte und optional beschichtete Metallelement einen Substratadapter bzw. mehrere Substratadapter bildet, die auf dem vorzugsweise nicht zu vereinzelnden Träger angeordnet sind. Der Träger bildet mit dem darauf befindlichen Substratadapter bzw. mit den darauf befindlichen Substratadaptern ein Zwischenprodukt, welches beispielsweise zum Kontaktieren eines Halbleiterelements benötigt wird. Das Zwischenprodukt bzw. die auf dem Träger befindlichen Substratadapter ist bzw. sind selbstständig handhabbar und kann bzw. können in einem zeitlich bzw. räumlich getrennten Vorgang weiterverarbeitet bzw. bei einem Verfahren zum Kontaktieren eines Halbleiterelements verwendet werden.

Optional kann es vorgesehen sein, dass die erste Seite des strukturierten Metallelements mit einem ersten Beschichtungssystem und/oder die zweite Seite des strukturierten Metallelements mit einem zweiten Beschichtungssystem beschichtet wird, wobei das Beschichten der ersten und/oder der zweiten Seite des strukturierten Metallelements vorzugsweise vor dem Positionieren des strukturierten Metallelements auf dem Träger erfolgt.

Im Folgenden schließt demnach die Bezeichnung strukturiertes Metallelement immer die Option ein, dass dieses strukturierte Metallelement entweder auf einer oder auf beiden Seiten bzw. auf der ersten und/oder der zweiten Seite beschichtet sein kann.

In einer Ausführungsform der Erfindung kann der Träger eine Folie, insbesondere eine Folie mit einstellbarer Klebekraft sein, wobei die Folie in einem Rahmen, insbesondere in einem Film-Frame, gespannt ist. Des Weiteren ist es möglich, dass die Folie endlos auf einem Spulenträger gewickelt ist. Beispielsweise kann es sich bei einer Trägerfolie um eine UV-Folie handeln.

Die Klebekraft, insbesondere die einstellbare Klebekraft einer Folie bzw. einer Trägerfolie kann zwischen dem Träger und dem Kontaktierungsmaterial geringer sein als die Klebekraft zwischen dem Kontaktierungsmaterial und dem strukturierten Metallelement. Bei einem Ablösen des strukturierten Metallelements von dem Träger bleibt das Kontaktierungsmaterial am strukturierten und optional beschichteten Metallelement haften. Mit anderen Worten ist die Adhäsion vorzugsweise zwischen dem Träger und dem Kontaktierungsmaterial geringer als zwischen dem Kontaktierungsmaterial und dem strukturierten und optional beschichteten Metallelement, so dass bei einem Ablösen des strukturierten und optional beschichteten Metallelements von dem Träger das Kontaktierungsmaterial am strukturierten und optional beschichteten Metallelement anhaften bleibt.

Bei dem auf eine Seite des Trägers aufgebrachten Kontaktierungsmaterial kann es sich beispielsweise um ein sinterbares Material bzw. um ein Sintermaterial handeln. Das Kontaktierungsmaterial kann eine Sinterpaste und/oder eine Sinterfolie sein, wobei das Sintermaterial und/oder die Sinterpaste und/oder die Sinterfolie beispielsweise Silber und/oder eine Silberverbindung enthalten kann.

In einer weiteren Ausführungsform der Erfindung kann das Kontaktierungsmaterial ein Lot und/oder ein Leitkleber sein.

Das Aufbringen des Kontaktierungsmaterials auf eine Seite eines Trägers kann durch Aufdrucken, insbesondere Siebdrucken und/oder Schablonendrucken, und/oder Rakeln und/oder Sprayen und/oder Jetten ausgeführt werden bzw. erfolgen.

Das Aufbringen des Kontaktierungsmaterials auf eine Seite des Trägers kann vorzugsweise mit einer vorbestimmten Struktur ausgeführt werden, wobei die vorbestimmte Struktur insbesondere passgenau zur Struktur des Metallelements, insbesondere des strukturierten Metallelements, ist. Vorzugsweise wird das Kontaktierungsmaterial auf eine Seite des Trägers mit einer derartigen Form bzw. mit einer derartigen Struktur aufgebracht, die der Form bzw. der Struktur des Metallelements des strukturierten Metallelements entspricht, so dass beim Fügen des strukturierten Metallelements mit dem mit Kontaktierungsmaterial versehenen Träger das strukturierte Kontaktierungsmaterial passgenau auf der Struktur des Metallelements auf- bzw. angebracht werden kann.

Das Metallelement kann eine Metallfolie, insbesondere eine Kupferfolie, sein.

Das optionale Beschichten der ersten und/oder der zweiten Seite des Metallelements mit einem ersten und/oder mit einem zweiten Beschichtungssystem kann beispielsweise mittels Galvanisierung durchgeführt werden. Die Beschichtung bzw. das erste und/oder das zweite Beschichtungssystem kann beispielsweise in einer Gestellgutgalvanik auf die erste und/oder die zweite Seite des Metallelements aufgebracht werden.

Das erste Beschichtungssystem und das zweite Beschichtungssystem sind vorzugsweise unterschiedliche Metalle, insbesondere Nickel, Silber und/oder Gold.

In einer weiteren Ausführungsform der Erfindung kann vorgesehen sein, dass das auf den Träger aufgebrachte Kontaktierungsmaterial, insbesondere die aufgebrachte Sinterpaste und/oder Sinterfolie und/oder das aufgebrachte Lot, vorgetrocknet wird. Das Vortrocknen des auf dem Träger aufgebrachten Kontaktierungsmaterials wird vorzugsweise vor der Positionierung des strukturierten und optional beschichteten Metallelements auf dem Träger durchgeführt. Mit anderen Worten ist das auf dem Träger aufgebrachte Kontaktierungsmaterial beim Fügen des strukturierten und optional beschichteten Metallelements mit dem Kontaktierungsmaterial bereits vorgetrocknet.

Das strukturierte und optional beschichtete Metallelement, insbesondere die zweite Seite des Metallelements kann während des Fügens, insbesondere während eines Verpressens, des Metallelements mit dem Träger mittels eines beheizten Stempels auf eine Temperatur von 60 °C - 100 °C, insbesondere von 70 °C - 90 °C, insbesondere von 80 °C, erwärmt werden.

Während des Verpressens kann auf die Seite des Trägers, auf die kein Kontaktierungsmaterial aufgebracht ist, ein Gegenhalter und/oder ein Gegenstempel wirken.

Bei dem beschriebenen Transferelement, das auf die zweite Seite des strukturierten und optional beschichteten Metallelements aufgebracht ist bzw. wird, kann es sich um eine Transferfolie, insbesondere eine selbstklebende Folie mit einer Klebstoff-Beschichtung, vorzugsweise eine PSA (pressure sensitive adhesive) Klebstoff-Beschichtung, handeln. Vorzugsweise ist das Transferelement eine Transferfolie bzw. das Transferelement weist eine Transferfolie auf.

Im Rahmen des erfindungsgemäßen Verfahrens ist es möglich, dass das mit dem Träger und/oder mit dem Kontaktierungsmaterial zusammengefügte, strukturierte, optional beschichtete, und optional mit einem Transferelement versehene Metallelement, vorzugsweise durch Sägen und/oder Laserschneiden und/oder Stanzen und/oder Ätzen und/oder Wasserstrahlschneiden, vereinzelt wird. Aufgrund des Vereinzelns des Transferelements und/oder des Metallelements wird auf einem Träger eine Anordnung mehrerer Substratadapter hergestellt bzw. zur Verfügung gestellt.

Es ist beispielsweise möglich, dass lediglich das Transferelement vereinzelt wird. Des Weiteren ist es denkbar, dass sowohl das Transferelement als auch das mit dem Kontaktierungsmaterial zusammengefügte Metallelement vereinzelt wird. Außerdem ist es möglich, dass lediglich das mit dem Kontaktierungsmaterial zusammengefügte Metallelement vereinzelt wird. Auch das Vereinzeln von Teilbereichen des Trägers ist denkbar. Vorzugsweise werden durch das Vereinzeln Freiräume zwischen benachbarten Stapeln geschaffen, wobei die Stapel aus einem Metallelementabschnitt sowie einem Kontaktierungsmaterialabschnitt bestehen und optional einen Transferelementabschnitt umfassen. Die einzelnen Stapel können nebeneinander angeordnet auf einem bzw. dem gemeinsamen Träger befestigt bzw. befindlich sein.

Ein Substratadapter, der mit einem bzw. mit dem erfindungsgemäßen Verfahren hergestellt ist, umfasst mindestens einen Metallelementabschnitt und mindestens einen Kontaktierungsmaterialabschnitt. Des Weiteren ist es möglich, dass der Substratadapter auch mindestens einen Transferelementabschnitt umfasst. Optional können diese Abschnitte auf einem Träger befindlich sein.

Mit dem erfindungsgemäßen Verfahren ist es möglich, eine Anordnung mit mehreren Substratadaptern auf einem Träger herzustellen.

Ein weiterer Aspekt der Erfindung betrifft ein Verfahren zum Kontaktieren eines Halbleiterelements, insbesondere eines Leistungsbauelements, mittels eines erfindungsgemäß hergestellten Substratadapters. Das erfindungsgemäße Kontaktierungsverfahren umfasst die Schritte:
- Herstellen eines Substratadapters mit einem Verfahren
   nach Anspruch 1 oder
   nach Anspruch 12 oder
   nach einem der Ansprüche 3-11 gemäß der von Anspruch 1 abhängigen Alternative oder
   nach Anspruch 13 gemäß der von Anspruch 1 abhängigen Alternative
- Ablösen eines vereinzelten Substratadapters, das das optional beschichteten Metallelement mit zusammengefügtem Kontaktierungsmaterial und das Transferelement umfasst, vom Träger,
- Positionieren des Substratadapters auf einem Halbleiterelement derart, dass das Kontaktierungsmaterial und das Halbleiterelement gegenüberliegen bzw. zueinander weisen,
- Anheften des Substratadapters auf dem Halbleiterelement durch Wärme-und/oder Druckbeaufschlagung,
- Entfernen des Transferelements und Freilegen der zweiten Seite des optional beschichteten Metallelements,
- Kontaktieren der zweiten Seite des optional beschichteten Metallelements mit einem Kontaktierungselement, insbesondere einem Bonddraht, insbesondere einem Kupfer-Bonddraht, und/oder einem Bond-Bändchen und/oder einem Kupfer-Clip.

Ein weiterer nebengeordneter Aspekt der Erfindung betrifft ein Verfahren zum Kontaktieren eines Halbleiterelements, insbesondere eines Leistungsbauelements, mittels eines erfindungsgemäß hergestellten Substratadapters. Das erfindungsgemäße Kontaktierungsverfahren umfasst die Schritte:
- Herstellen eines Substratadapters (27) mit einem Verfahren nach Anspruch 2 oder
   nach einem der Ansprüche 3-11 gemäß der von Anspruch 2 abhängigen Alternative oder
   nach Anspruch 13 gemäß der von Anspruch 2 abhängigen Alternative;
- Ablösen eines vereinzelten Substratadapters, das, das optional beschichtete, Metallelement mit zusammengefügtem Kontaktierungsmaterial umfasst, vom Träger,
- Positionieren des Substratadapters auf einem Halbleiterelement derart, dass das Kontaktierungsmaterial und das Halbleiterelement zueinander weisen,
- Anheften des Substratadapters auf dem Halbleiterelement durch Wärme-und/oder Druckbeaufschlagung,
- Kontaktieren der zweiten Seite des optional beschichteten Metallelements mit einem Kontaktierungselement, insbesondere einem Bonddraht, insbesondere einem Kupfer-Bonddraht, und/oder einem Bond-Bändchen und/oder einem Kupfer-Clip.

Des Weiteren kann das erfindungsgemäße Kontaktierungsverfahren den Verfahrensschritt umfassen, dass der Substratadapter mit dem Halbleiterelement und/oder einem das Halbleiterelement umfassende Substrat versintert und/oder verlötet und/oder verklebt wird.

Mit Hilfe des erfindungsgemäßen Verfahrens zur Herstellung eines Substratadapters wird ein Substratadapter zur Verfügung gestellt, der inklusive des Kontaktierungsmaterials einem Kunden und/oder einer weiteren Ver- bzw. Bearbeitungslinie zur Verfügung gestellt werden kann. Der Substratadapter bzw. eine Anordnung mit mehreren Substratadaptern kann auf einem Film-Frame bereitgestellt werden. In einer derartigen Lieferform kann es direkt in einem nächsten Prozess bzw. Verfahrensschritt vom Film-Frame entnommen und auf ein Halbleiterelement, insbesondere auf ein Leistungsbauelement, gesintert werden. Dies entspricht der sogenannten Pick and Place-Technologie. Das heißt, dass der Substratadapter mit Hilfe einer Robotik bzw. einer Greifvorrichtung oder einer Düse bzw. einer Ansaugvorrichtung vom Träger bzw. dem Film-Frame gelöst und zu dem entsprechenden Halbleiterelement transportiert werden kann.

Nachfolgend wird die Erfindung anhand von Ausführungsbeispielen und unter Bezugnahme auf die beigefügten Zeichnungen mit weiteren Einzelheiten näher erläutert.

Diese zeigen:
- Fig. 1 - 6: einzelne Stufen und Schritte des Verfahrens zur Herstellung eines speziellen Substratadapters für Halbleiter-Leistungsmodule, wobei der Substratadapter das Halbleiter-Leistungsmodul von mechanischen Beanspruchungen schützen und ein Bonden mittels Cu-Bonddraht ermöglichen soll;
- Fig. 7 - 11: eine weitere beispielhafte Ausführung des Verfahrens mit den einzelnen Stufen bzw. Schritten zur Herstellung eines Substratadapters;
- Fig. 12 - 14: einzelne Stufen bzw. Schritte des erfindungsgemäßen Verfahrens zur Kontaktierung eines Halbleiterelements mittels eines Substratadapters;
- Fig. 15: ein kontaktiertes Halbleiterelement; und
- Fig. 16 - 21: eine weitere beispielhafte Ausführung des Verfahrens mit den einzelnen Stufen bzw. Schritten zur Herstellung eines Substratadapters sowie des Verfahrens zur Kontaktierung eines Halbleiterelements mittels eines Substratadapters.

Im Folgenden werden für gleiche und gleichwirkende Teile gleiche Bezugsziffern verwendet.

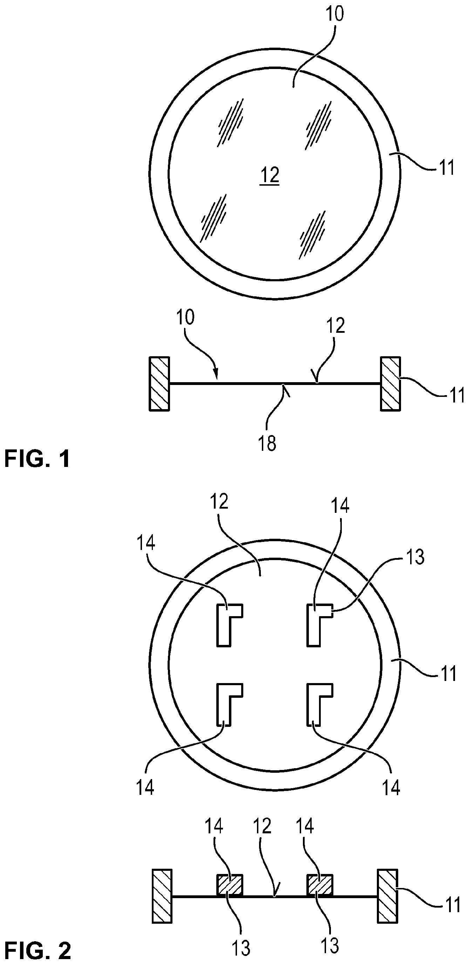

In den Fig. 1 - 6 werden die einzelnen Verfahrensschritte und Zwischenprodukte sowohl in einer Draufsicht als auch im Schnitt dargestellt.

In Fig. 1 ist ein Träger 10 dargestellt, der auf einen sogenannten Film-Frame 11 gespannt ist. Bei dem dargestellten Träger 10 handelt es sich um eine Folie mit einstellbarer Klebekraft. Beim Einspannen der Folie 10 in den Film-Frame 11 ist darauf zu achten, dass die Folie bzw. der Träger 10 eine ausreichende mechanische Stabilität aufweist, so dass bei einem eventuell nachfolgenden Trocknungsprozess die darauf befindlichen Elemente bzw. ein darauf befindliches Kontaktierungsmaterial 13 nicht verformt werden.

Auf eine Seite 12 des Trägers 10 wird gemäß Fig. 2 ein Kontaktierungsmaterial 13 aufgebracht. Bei dem Kontaktierungsmaterial 13 handelt es sich im dargestellten Beispiel um eine Sinterpaste. Vorzugsweise enthält diese Sinterpaste Silber und/oder eine Silberverbindung. Das Kontaktierungsmaterial 13 wird auf die Seite 12 des Trägers 10 strukturiert bzw. mit einer Struktur 14 aufgebracht. Mit anderen Worten wird das Kontaktierungsmaterial 13 in vier Einzelabschnitten aufgebracht, wobei die einzelnen Abschnitte die grobe Form eines L aufweisen. Das Aufbringen des Kontaktierungsmaterials 13 auf der Seite 12 des Trägers 10 erfolgt vorzugsweise durch Aufdrucken, insbesondere durch Siebdrucken und/oder Schablonendrucken. Das auf die Seite 12 des Trägers 10 aufgedruckte Kontaktierungsmaterial 13, nämlich die Sinterpaste, wird anschließend vorgetrocknet. Die vorzugsweise verwendete Ag-Sinterpaste wird beispielsweise für ca. 10 Minuten bei ca. 100 °C getrocknet.

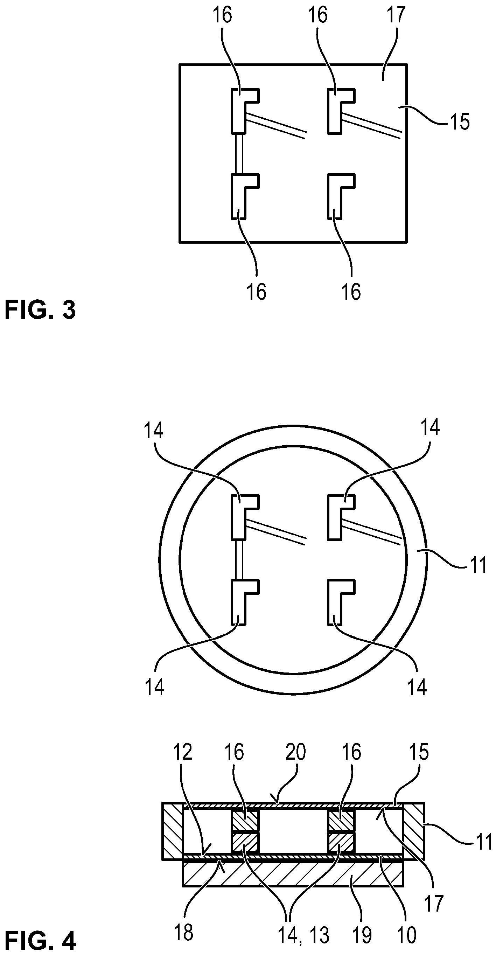

Fig. 3 zeigt eine Draufsicht auf eine erste Seite eines Metallelements 15. Bei dem Metallelement 15 handelt es sich vorzugsweise um eine Metallfolie, insbesondere eine Kupferfolie. Das elektrisch leitende Metallelement 15 wird strukturiert. Das Strukturieren kann beispielsweise durch Ätzen und/oder Stanzen und/oder Lasern erfolgen. Mit anderen Worten wird in ein elektrisch leitendes Metallelement 15 eine Struktur bzw. mehrere Strukturen 16 eingebracht. Die Strukturen 16 bzw. Formen entsprechen vorzugsweise den Strukturen 14 des Kontaktierungselements 13. Die Struktur 16 des Metallelements 15 entspricht vorzugsweise der Form des später zu verwendenden Substratadapters.

Das Aufbringen des Kontaktierungsmaterials 13 auf die Seite 12 des Trägers 10 erfolgt mit einer vorbestimmten Struktur 14, wobei die Struktur 14 passgenau zur Struktur 16 des Metallelements 15 ausgeführt ist. Demnach sind die Strukturen 16 des elektrisch leitenden Metallelements 15 ebenfalls als L-Formen ausgeführt, die den gleichen Abstand zueinander aufweisen, wie die L-Formen bzw. wie die einzelnen Strukturen 14 des Kontaktierungsmaterials 13.

In Fig. 4 wird der weitere Schritt des erfindungsgemäßen Verfahrens zum Herstellen eines Substratadapters dargestellt. Diese betrifft das Positionieren des strukturierten Metallelements 15 auf dem Träger 10, wobei die Positionierung derart erfolgt, dass eine erste Seite 17 des Metallelements 15 und die mit dem Kontaktierungsmaterial 13 versehene Seite 12 des Trägers 10 gegenüberliegend angeordnet sind. Das elektrisch leitende und strukturierte Metallelement 15 wird dabei passgenau auf die mit Sinterpaste beschichtete Trägerfolie aufgelegt. Damit der Träger 10 bzw. die Trägerfolie nicht verzogen wird, wirkt auf die Unterseite bzw. die zweite Seite 18 des Trägers 10, die kein Kontaktierungsmaterial 13 aufweist, ein Gegenhalter 19.

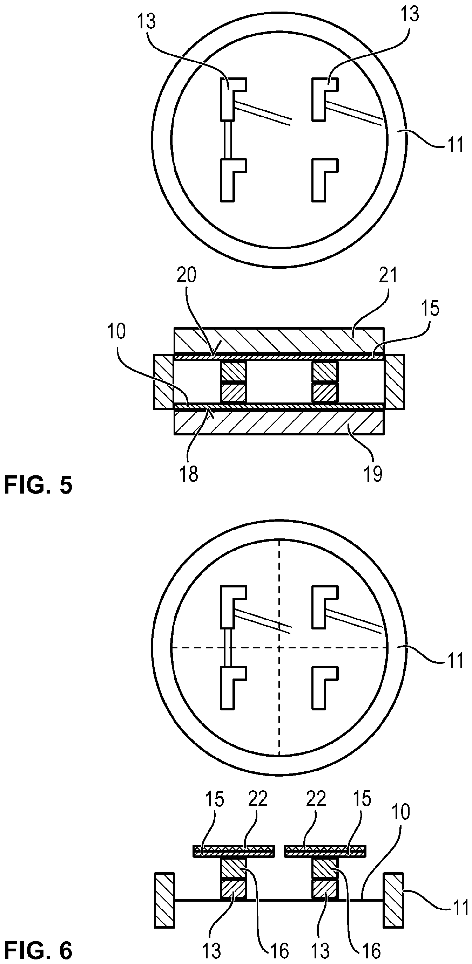

Wie in Fig. 5 zu erkennen ist, folgt ein Fügen des strukturierten Metallelements 15 mit dem mit Kontaktierungsmaterial 13 versehenen Träger 10. Das Metallelement 15, insbesondere die zweite Seite 20 des Metallelements 15 wird während des Fügens bzw. während des Verpressens mittels eines beheizten Stempels 21 auf eine Temperatur von 60 °C - 100 °C, insbesondere von 70 °C - 90 °C, insbesondere von 80 °C, erwärmt. Durch Wärme- und/oder Druckbeaufschlagung wird das Metallelement 15 mit dem Träger 10 bzw. mit dem auf dem Träger 10 befindlichen Kontaktierungsmaterial 13 verpresst. Auch während des Verpressens wirkt auf die zweite Seite 18 des Trägers 10 der Gegenhalter 19.

Nach dem Verpressen bzw. Fügen des strukturierten Metallelements 15 mit dem mit Kontaktierungsmaterial 13 versehenen Träger 10 wird auf die zweite Seite 20 des strukturierten Metallelements 15 ein Transferelement 22 aufgebracht. Bei dem Transferelement 22 handelt es sich vorzugsweise um eine Transferfolie. Bei der Transferfolie kann es sich insbesondere um eine selbstklebende Folie mit einer Klebstoff-Beschichtung handeln. Vorzugsweise wird eine PSA (pressure sensitive adhesive) Klebstoff-Beschichtung bevorzugt.

Wie bereits beschrieben, kann auch der Träger 10 eine Folie bzw. eine Trägerfolie sein. Insbesondere ist der Träger 10 eine Folie mit einstellbarer Klebekraft. Die Klebekraft der Folie bzw. Trägerfolie 10 wird vorzugsweise derart eingestellt, dass die Klebekraft zwischen dem Träger 10 bzw. der ersten Seite 12 des Trägers 10 und dem Kontaktierungsmaterial 13 geringer ist als die Klebekraft zwischen dem Kontaktierungsmaterial 13 und dem strukturierten Metallelement 15, bzw. der ersten Seite 17 des strukturierten Metallelements 15. Eine derartige Einstellung der Klebekraft ermöglicht es, dass das Kontaktierungsmaterial 13 bei einem Ablösen des strukturierten Metallelements 15 und dem daran befindlichen Kontaktierungsmaterial 13 von dem Träger 10, am strukturierten Metallelement 15 haften bleibt. Mit anderen Worten wird bei einem Ablösen des strukturierten Metallelements 15 auch das am Metallelement 15 befindliche Kontaktierungsmaterial 13 mitabgelöst, da das Kontaktierungsmaterial 13 vom Träger 10 bzw. von der ersten Seite 12 des Trägers 10 aufgrund einer geringeren Klebekraft lösbar ist.

In Fig. 6 wird das Vereinzeln des Transferelements 22 sowie des strukturierten und mit Kontaktierungsmaterial 13 zusammengefügten Metallelements 15 zur weiteren Verarbeitung dargestellt. Demnach kann das mit dem Träger 10 und/oder mit dem Kontaktierungsmaterial 13 zusammengefügte, strukturierte und optional beschichtete und mit dem Transferelement 22 versehene Metallelement 15 vorzugsweise durch Sägen und/oder Laserschneiden und/oder Stanzen und/oder Ätzen und/oder Wasserstrahlschneiden, vereinzelt werden. Aufgrund der Vereinzelung, die beispielsweise entlang der Strukturen 14 des Kontaktierungsmaterials 13 sowie der Strukturen 16 des Metallelements 15 folgt, können einzelne Substratadapter herausgearbeitet bzw. hergestellt werden. Vorzugsweise wird beim Vereinzeln der Träger 10 nicht getrennt bzw. lediglich abschnittsweise. Demnach können die vereinzelten Substratadapter auf dem Träger 10 haften bleiben. Mit anderen Worten betrifft das Vereinzeln vorzugsweise lediglich das Transferelement 22 sowie das mit dem Kontaktierungsmaterial 13 zusammengefügte Metallelement 15. Mit Hilfe des Film-Frames 11 und dem Träger 10 können die somit vereinzelten Substratadapter in einfacher Art und Weise transportiert werden.

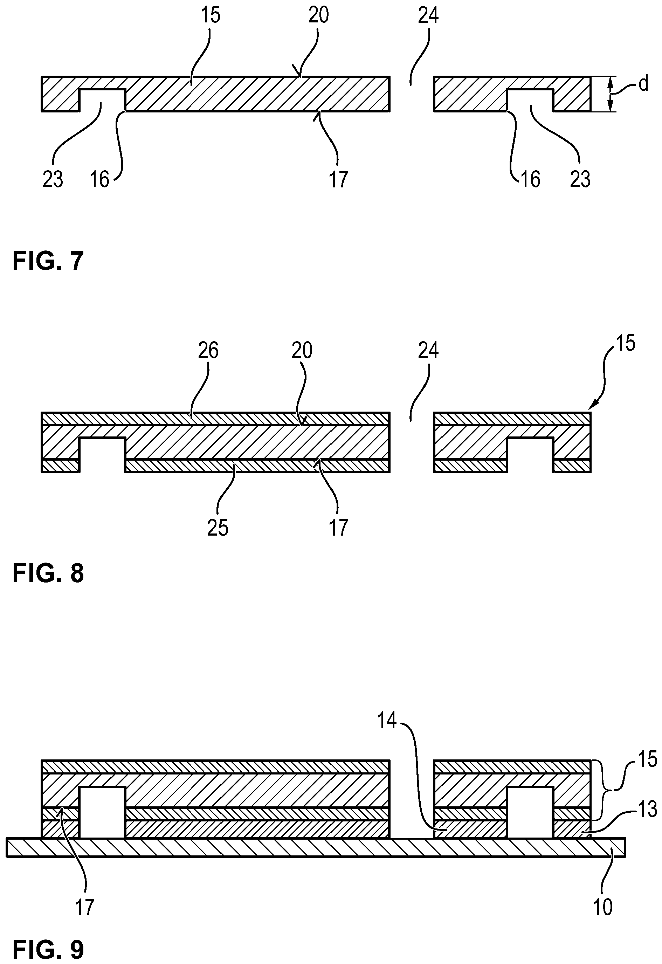

Die folgenden Figuren 7 bis 11 betreffen eine weitere Ausführungsform des erfindungsgemäßen Verfahrens zum Herstellen eines Substratadapters.

In Fig. 7 ist ein Metallelement 15, nämlich eine Kupferfolie dargestellt, die zunächst strukturiert wird. Hierzu werden auf die erste Seite 17 des Metallelements 15 Ausnehmungen 23 eingearbeitet. Aufgrund der eingearbeiteten Ausnehmungen 23 sowie einer Trennstelle 24, welche das Metallelement 15 auf der gesamten Dicke d trennt, ergibt sich die Struktur 16 auf der ersten Seite 17 des Metallelements 15.

Es erfolgt gemäß Fig. 8 ein Beschichten sowohl der ersten Seite 17 des Metallelements 15 als auch der zweiten Seite 20 des Metallelements 15 mit einem ersten Beschichtungssystem 25 auf der ersten Seite 17 und einem zweiten Beschichtungssystem 26 auf der zweiten Seite 20. Das optionale Beschichten eines strukturierten Metallelements 15 erfolgt demnach vorzugsweise nach dem Strukturieren des Metallelements 15. Das Beschichten der ersten Seite 17 sowie der zweiten Seite 20 des Metallelements 15 wird vorzugsweise mittels Galvanisierung durchgeführt.

Das erste Beschichtungssystem 25 und das zweite Beschichtungssystem 26 sind vorzugsweise unterschiedliche Metalle, vorzugsweise Nickel, Silber und/oder Gold.

In Fig. 9 wird ein Träger 10 mit einem darauf aufgebrachten Kontaktierungsmaterial 13 dargestellt. Das Kontaktierungsmaterial 13 ist beispielswiese eine silberhaltige bzw. silberlegierungshaltige Sinterpaste. Das Kontaktierungsmaterial 13 weist eine Struktur 14 auf, wobei die Struktur 14 der Struktur 16 des Metallelements 15 gleicht. Das beschichtete Metallelement 15 wird auf dem Träger 10, insbesondere auf dem Kontaktierungsmaterial 13 positioniert. Vorzugsweise wird die erste Seite 17 des Metallelements 15 mit dem darauf befindlichen ersten Beschichtungssystem 25 auf dem Kontaktierungsmaterial 13 angeordnet. Es folgt ein Fügen des strukturierten Metallelements 15 mit dem Kontaktierungsmaterial 13. Dieses Fügen kann beispielsweise mittels Verpressen, wie dieses bereits im Zusammenhang mit der Figur 5 beschrieben ist, erfolgen.

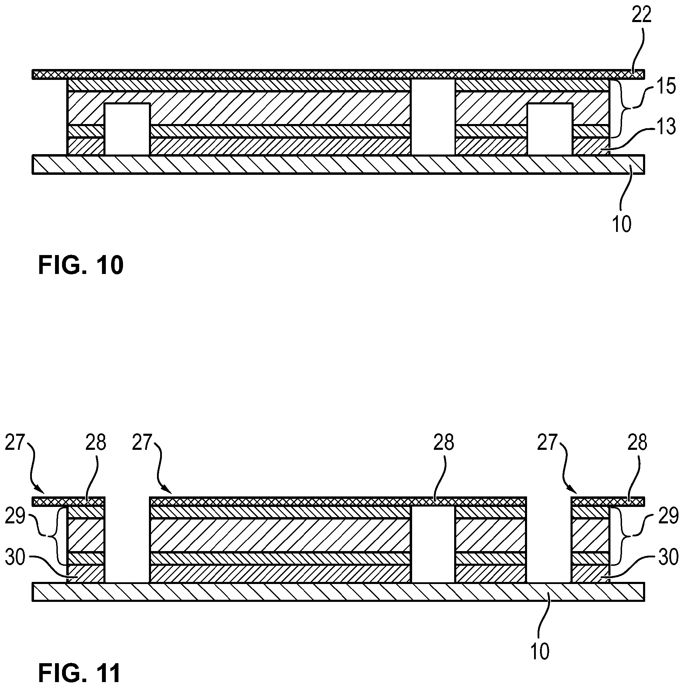

Gemäß Fig. 10 kann ein Transferelement 22 aufgebracht werden. Das Transferelement 22 ist beispielsweise eine Transferfolie, wobei diese auf der zweiten Seite 20 des Metallelements 15, insbesondere auf dem zweiten Beschichtungssystem 26 aufgebracht wird. Vorzugsweise bedeckt das Transferelement 22 vollständig das beschichtete und strukturierte Metallelement 15.

In Fig. 11 wird wiederum das Vereinzeln des Transferelements 22 sowie des strukturierten, beschichteten und mit Kontaktierungsmaterial 13 zusammengefügte Metallelements 15 dargestellt. Das Vereinzeln kann, wie bereits beschrieben, durch Sägen und/oder Laserschneiden und/oder Stanzen und/oder Ätzen und/oder Wasserstrahlschneiden erfolgen. Aufgrund des Vereinzelns ergeben sich einzelne Stapel 27, die jeweils aus einem Transferelementabschnitt 28, einem beschichteten Metallelementabschnitt 29 und einem Kontaktierungsmaterialabschnitt 30 besteht. Der dargestellte Träger 10 wird im vorliegenden Fall nicht getrennt. Des Weiteren ist ersichtlich, dass beispielsweise der mittlere Stapel 27 durch zwei nebeneinander angeordnete Stapel gebildet wird, die jedoch nur mit einem Transferelementabschnitt 28 verbunden sind. Die einzelnen Stapel 27 stellen die auf ein Halbleiterelement aufzubringenden Substratadapter dar. Die einzelnen Stapel 27 bzw. Substratadapter können auf dem Träger 10 transportiert werden.

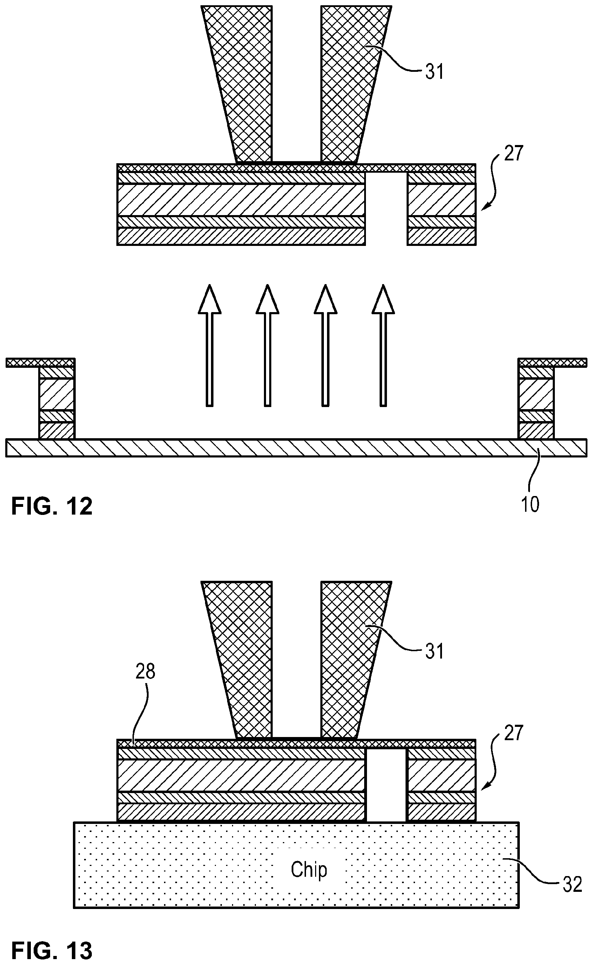

In Fig. 12 wird dargestellt, dass in einem späteren Kundenprozess mittels Pick and Place-Technologie mit Hilfe eines Greifers oder einer Saugvorrichtung bzw. Düse 31 der mittlere Stapel 27 bzw. der Substratadapter vom Träger 10 gelöst werden kann. Der Stapel bzw. Substratadapter 27 wird auf einem Halbleiterelement 32 positioniert, wobei das Kontaktierungsmaterial 13 und das Halbleiterelement 32 gegenüberliegen (siehe Fig. 13). Durch Wärme und/oder Druckbeaufschlagung erfolgt ein Anheften des Substratadapters bzw. des Stapels 27 auf dem Halbleiterelement 32.

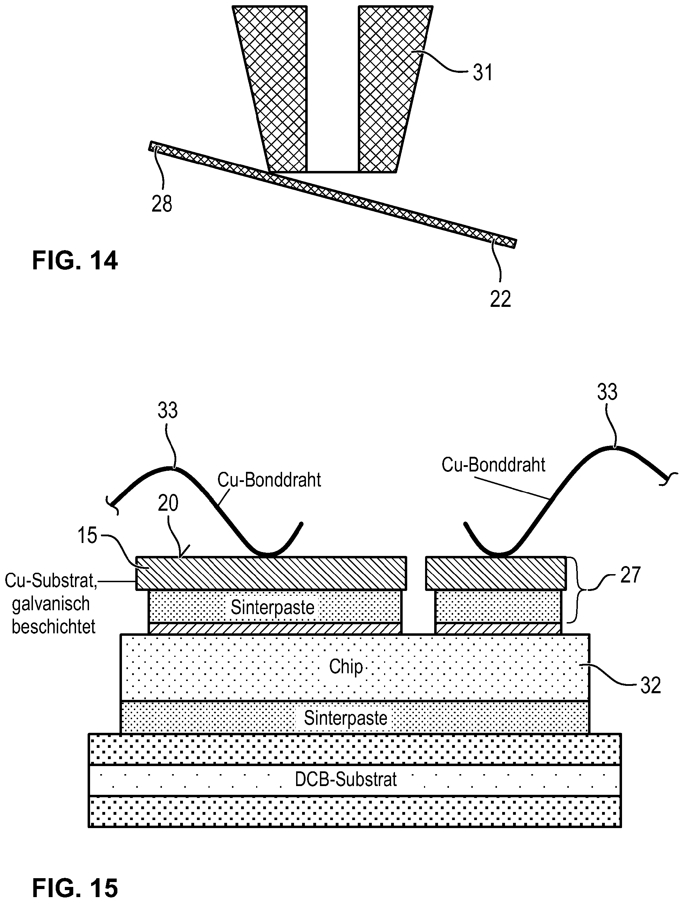

Im nachfolgenden Schritt (siehe Fig. 14) wird das Transferelement 22 bzw. der Transferelementabschnitt 28 entfernt und die zweite Seite 20 bzw. das zweite Beschichtungssystem 26 des Metallelements 15 freigelegt.

Wie in Fig. 15 dargestellt ist, kann die zweite Seite 20 des optional beschichteten Metallelements 15 mit einem Kontaktierungselement, nämlich einem Kupfer-Bonddraht 33 kontaktiert werden. Es folgt anschließend ein Sintern und/oder der übliche Aufbau- und Verbindungsprozess zum Herstellen eines kontaktierten Halbleiterelements 32 bzw. eines Leistungsbauelements.

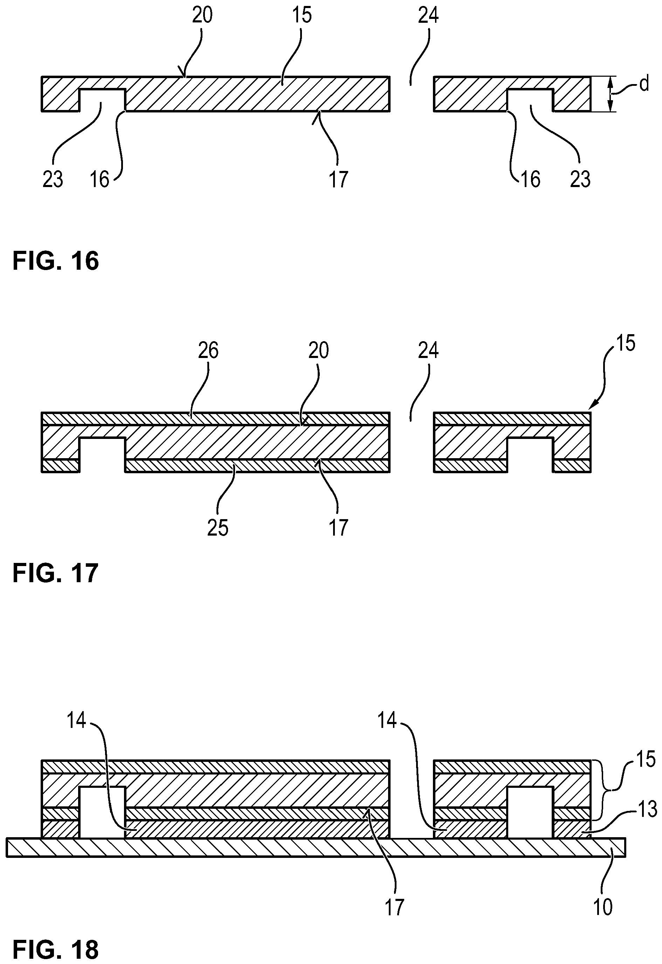

Die im Folgenden beschriebenen Figuren 16 bis 21 betreffen eine weitere Ausführungsform des erfindungsgemäßen Verfahrens zum Herstellen eines Substratadapters sowie ein Verfahren zur Kontaktierung eines Halbleiterelements mittels eines Substratadapters.

In Fig. 16 ist ein Metallelement 15, nämlich eine Kupferfolie dargestellt, die zunächst strukturiert wird. Hierzu werden auf die erste Seite 17 des Metallelements 15 Ausnehmungen 23 eingearbeitet. Aufgrund der eingearbeiteten Ausnehmungen 23 sowie einer Trennstelle 24, welche das Metallelement 15 auf der gesamten Dicke d trennt, ergibt sich die Struktur 16 auf der ersten Seite 17 des Metallelements 15.

Es erfolgt gemäß Fig. 17 ein Beschichten sowohl der ersten Seite 17 des Metallelements 15 als auch der zweiten Seite 20 des Metallelements 15 mit einem ersten Beschichtungssystem 25 auf der ersten Seite 17 und einem zweiten Beschichtungssystem 26 auf der zweiten Seite 20. Das optionale Beschichten eines strukturierten Metallelements 15 erfolgt demnach vorzugsweise nach dem Strukturieren des Metallelements 15. Das Beschichten der ersten Seite 17 sowie der zweiten Seite 20 des Metallelements 15 wird vorzugsweise mittels Galvanisierung durchgeführt.

Das erste Beschichtungssystem 25 und das zweite Beschichtungssystem 26 sind vorzugsweise unterschiedliche Metalle, vorzugsweise Nickel, Silber und/oder Gold.

In Fig. 18 wird ein Träger 10 mit einem darauf aufgebrachten Kontaktierungsmaterial 13 dargestellt. Das Kontaktierungsmaterial 13 ist beispielswiese eine silberhaltige bzw. silberlegierungshaltige Sinterpaste. Das Kontaktierungsmaterial 13 weist eine Struktur 14 auf, wobei die Struktur 14 der Struktur 16 des Metallelements 15 gleicht. Das beschichtete Metallelement 15 wird auf dem Träger 10, insbesondere auf dem Kontaktierungsmaterial 13 positioniert. Vorzugsweise wird die erste Seite 17 des Metallelements 15 mit dem darauf befindlichen ersten Beschichtungssystem 25 auf dem Kontaktierungsmaterial 13 angeordnet. Es folgt ein Fügen des strukturierten Metallelements 15 mit dem Kontaktierungsmaterial 13. Dieses Fügen kann beispielsweise mittels Verpressen, wie dieses bereits im Zusammenhang mit der Figur 5 beschrieben ist, erfolgen.

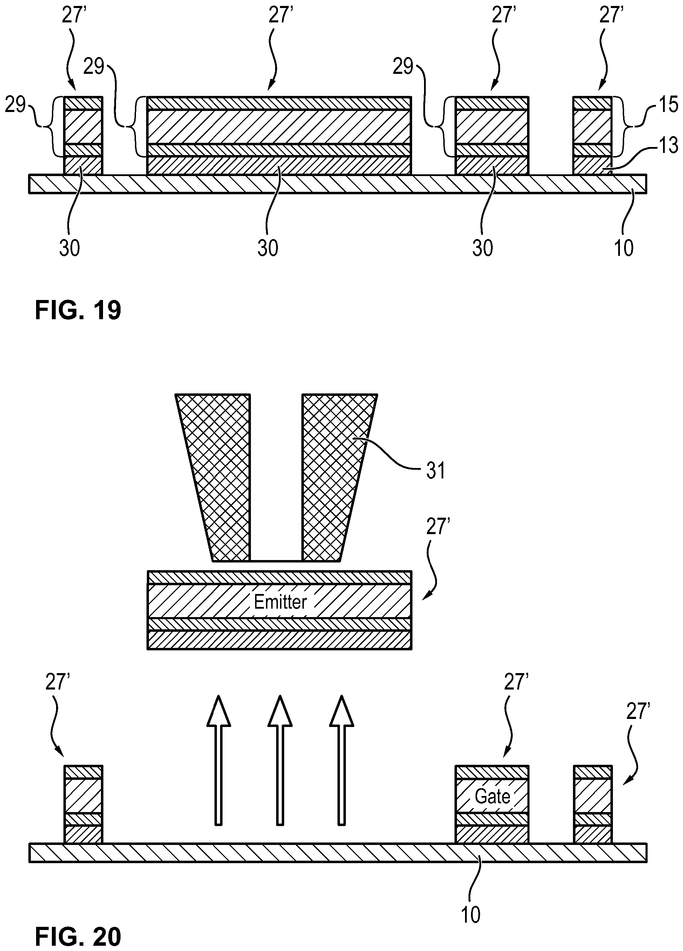

In Fig. 19 wird wiederum das Vereinzeln des strukturierten, beschichteten und mit Kontaktierungsmaterial 13 zusammengefügte Metallelements 15 dargestellt. Das Vereinzeln kann durch Sägen und/oder Laserschneiden und/oder Stanzen und/oder Ätzen und/oder Wasserstrahlschneiden erfolgen. Aufgrund des Vereinzeins ergeben sich einzelne Stapel bzw. Substratadapter 27', die jeweils aus einem beschichteten Metallelementabschnitt 29 und einem Kontaktierungsmaterialabschnitt 30 bestehen. Der dargestellte Träger 10 wird im vorliegenden Fall nicht getrennt. Die einzelnen Stapel 27' stellen die auf ein Halbleiterelement aufzubringenden Substratadapter dar. Die einzelnen Stapel 27' bzw. Substratadapter können auf dem Träger 10, der beispielsweise in einem Film-Frame eingespannt sein kann, transportiert werden.

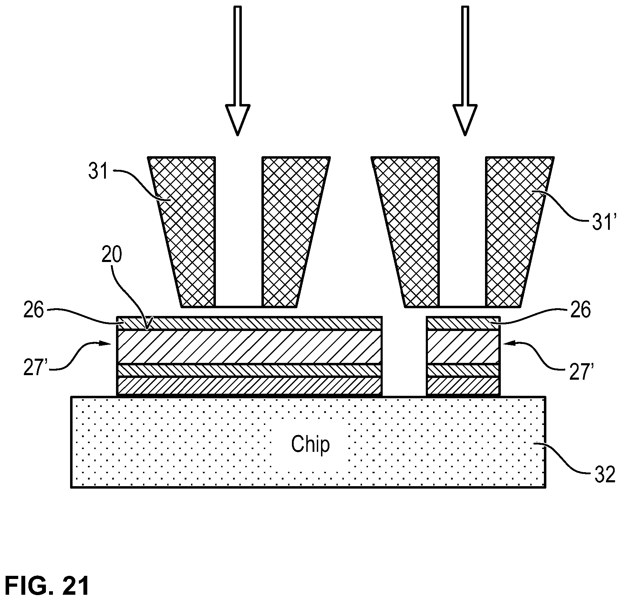

In Fig. 20 wird dargestellt, dass in einem späteren Kundenprozess mittels Pick and Place-Technologie mit Hilfe eines Greifers oder einer Saugvorrichtung bzw. Düse 31 der mittlere Stapel 27' bzw. der Substratadapter vom Träger 10 gelöst werden kann. Der Stapel bzw. Substratadapter 27' ist im vorliegenden Fall ein Emitter, der auf einem Halbleiterelement 32 positioniert wird, wobei das Kontaktierungsmaterial 13 und das Halbleiterelement 32 gegenüberliegen (siehe Fig. 21). Durch Wärme und/oder Druckbeaufschlagung erfolgt ein Anheften des Substratadapters bzw. des Stapels 27' auf dem Halbleiterelement 32. Der zusätzlich auf dem Träger 10 befindliche Stapel bzw. Substratadapter 27', der ein Gate darstellt, kann separat auf dem Halbleiterelement 32 aufgetragen werden. Dies kann, wie in Fig. 21 dargestellt, mit einer weiteren, zusätzlichen Saugvorrichtung bzw. Düse 31' erfolgen. Bei dem in Fig. 13 dargestellten Verfahrensschritt kann das Positionieren des Emitters und des Gates in einem Schritt erfolgen, da die beiden Stapel 27 mit einem Transferelementabschnitt 28 miteinander verbunden sind.

Die zweite Seite 20 bzw. das zweite Beschichtungssystem 26 des Metallelements 15 kann vorzugsweise in einem darauf folgenden und nicht dargestellten Verfahrensschritt beispielsweise mit einem Kupfer-Bonddraht kontaktiert werden. Es folgt anschließend ein Sintern und/oder der übliche Aufbau- und Verbindungsprozess zum Herstellen eines kontaktierten Halbleiterelements 32 bzw. eines Leistungsbauelements.

### Bezugszeichenliste

- 10: Träger
- 11: Film-Frame
- 12: erste Seite Träger
- 13: Kontaktierungsmaterial
- 14: Struktur Kontaktierungsmaterial
- 15: Metallelement
- 16: Struktur Metallelement
- 17: erste Seite Metallelement
- 18: zweite Seite Träger
- 19: Gegenhalter
- 20: zweite Seite Metallelement
- 21: Stempel
- 22: Transferelement
- 23: Ausnehmung
- 24: Trennstelle
- 25: erstes Beschichtungssystem
- 26: zweites Beschichtungssystem
- 27, 27': Stapel, Substratadapter
- 28: Transferelementabschnitt
- 29: Metallelementabschnitt
- 30: Kontaktierungsmaterialabschnitt
- 31, 31': Düse
- 32: Halbleiterelement
- 33: Kupfer-Bonddraht
- d: Dicke Metallelement

## Patentansprüche

1. Verfahren zum Herstellen eines Substratadapters (27), der insbesondere zum Kontaktieren von Halbleiterelementen (32) dient, umfassend die Schritte:
- Aufbringen eines Kontaktierungsmaterials (13) auf eine Seite (12) eines Trägers (10),
- Strukturieren eines elektrisch leitenden Metallelements (15),
- Positionieren des strukturierten Metallelements (15) auf dem Träger (10) derart, dass eine erste Seite (17) des Metallelements (15) und die mit dem Kontaktierungsmaterial (13) versehene Seite (12) des Trägers (10) gegenüber angeordnet sind,
- Fügen des strukturierten Metallelements (15) mit dem mit Kontaktierungsmaterial (13) versehenen Träger (10),
- Aufbringen eines Transferelements (22) auf die zweite Seite (20) des strukturierten Metallelements (15),
- Vereinzeln des Transferelements (22) und/oder des strukturierten und mit Kontaktierungsmaterial (13) zusammengefügten Metallelements (15) zur weiteren Verarbeitung.

2. Verfahren zum Herstellen eines Substratadapters (27'), der insbesondere zum Kontaktieren von Halbleiterelementen (32) dient, umfassend die Schritte:
- Aufbringen eines Kontaktierungsmaterials (13) auf eine Seite (12) eines Trägers (10),
- Strukturieren eines elektrisch leitenden Metallelements (15),
- Positionieren des strukturierten Metallelements (15) auf dem Träger (10) derart, dass eine erste Seite (17) des Metallelements (15) und die mit dem Kontaktierungsmaterial (13) versehene Seite (12) des Trägers (10) gegenüber angeordnet sind,
- Fügen des strukturierten Metallelements (15) mit dem mit Kontaktierungsmaterial (13) versehenen Träger (10),
- Vereinzeln des strukturierten und mit Kontaktierungsmaterial (13) zusammengefügten Metallelements (15) zur weiteren Verarbeitung.

3. Verfahren nach Anspruch 1 oder 2,
**gekennzeichnet durch**
Beschichten der ersten Seite (17) des strukturierten Metallelements (15) mit einem ersten Beschichtungssystem (25) und/oder einer zweiten Seite (20) des strukturierten Metallelements (15) mit einem zweiten Beschichtungssystem (26), insbesondere vor dem Positionieren des strukturierten Metallelements (15) auf dem Träger (10).

4. Verfahren nach einem der Ansprüche 1 bis 3,
**dadurch gekennzeichnet, dass**
der Träger (10) eine Folie, insbesondere eine Folie mit einstellbarer Klebekraft, ist, die in einen Rahmen, insbesondere in einen Film-Frame (11), gespannt ist oder endlos auf einem Spulenträger gewickelt ist.

5. Verfahren nach Anspruch 4,
**dadurch gekennzeichnet, dass**
die Klebekraft zwischen dem Träger (10) und dem Kontaktierungsmaterial (13) geringer ist als die Klebekraft zwischen dem Kontaktierungsmaterial (13) und dem strukturierten Metallelement (15), derart, dass das Kontaktierungsmaterial (13) bei einem Ablösen des strukturierten Metallelements (15) von dem Träger (10), am strukturierten Metallelement (15) haftet.

6. Verfahren nach einem der Ansprüche 1 bis 5,
**dadurch gekennzeichnet, dass**
das Kontaktierungsmaterial (13) ein Sintermaterial ist.

7. Verfahren nach einem der vorangegangenen Ansprüche,
**dadurch gekennzeichnet, dass**
das Kontaktierungsmaterial (13) ein Lot und/oder ein Leitkleber ist.

8. Verfahren nach einem der vorangegangenen Ansprüche,
**dadurch gekennzeichnet, dass**
das Aufbringen des Kontaktierungsmaterials (13) auf eine Seite (12) des Trägers (10) mit einer vorbestimmten Struktur (14) ausgeführt wird, die, insbesondere passgenau, zur Struktur (16) des Metallelements (15), insbesondere des strukturierten Metallelements, ist.

9. Verfahren nach einem der Ansprüche 3 bis 8,
**dadurch gekennzeichnet, dass**
das Beschichten der ersten Seite (17) und/oder der zweiten Seite (20) des Metallelements (15) mittels Galvanisierung durchgeführt wird.

10. Verfahren nach einem der vorangegangenen Ansprüche,
**dadurch gekennzeichnet, dass**
das Metallelement (15), insbesondere die zweite Seite (20) des Metallelements (15), mittels eines beheizten Stempels (21), während des Fügens, insbesondere während eines Verpressens, des Metallelements (15) mit dem Träger (10) auf eine Temperatur von 60 °C - 100 °C, insbesondere von 70 °C - 90 °C, insbesondere von 80 °C, erwärmt wird.

11. Verfahren nach Anspruch 10,
**dadurch gekennzeichnet, dass**
während des Verpressens auf die Seite (18) des Trägers (10), die vorzugsweise kein Kontaktierungsmaterial (13) aufweist, ein Gegenhalter (19) und/oder ein Gegenstempel wirkt.

12. Verfahren nach einem der vorangegangenen Ansprüche, insbesondere nach einem der Ansprüche 1 oder 3 bis 11,
**dadurch gekennzeichnet, dass**
das Transferelement (22) eine Transferfolie, insbesondere eine selbstklebende Folie mit einer Klebstoff-Beschichtung, vorzugsweise eine PSA (pressure sensitive adhesive) Klebstoff-Beschichtung, ist.

13. Verfahren nach einem der vorangegangenen Ansprüche,
**dadurch gekennzeichnet, dass**
das mit dem Träger (10) und/oder mit dem Kontaktierungsmaterial (13) zusammengefügte, strukturierte, optional beschichtete, und optional mit dem Transferelement (22) versehene Metallelement (15), vorzugsweise durch Sägen und/oder Laserschneiden und/oder Stanzen und/oder Ätzen und/oder Wasserstrahlschneiden, vereinzelt wird.

14. Verfahren zum Kontaktieren eines Halbleiterelements (32), insbesondere Leistungsbauelements, mittels eines Substratadapters (27), umfassend die Schritte:
- Herstellen eines Substratadapters (27) mit einem Verfahren nach Anspruch 1 oder
nach Anspruch 12 oder
nach einem der Ansprüche 3-11 gemäß der von Anspruch 1 abhängigen Alternative oder
nach Anspruch 13 gemäß der von Anspruch 1 abhängigen Alternative;
- Ablösen eines vereinzelten Substratadapters (27), das das optional beschichtete Metallelement (15) mit zusammengefügtem Kontaktierungsmaterial (13) und das Transferelement (22) umfasst, vom Träger (10),
- Positionieren des Substratadapters (27) auf einem Halbleiterelement (32) derart, dass das Kontaktierungsmaterial (13) und das Halbleiterelement (32) zueinander weisen,
- Anheften des Substratadapters (27) auf dem Halbleiterelement (32) durch Wärme- und/oder Druckbeaufschlagung,
- Entfernen des Transferelements (22) und Freilegen der zweiten Seite (20) des optional beschichteten Metallelements (15),
- Kontaktieren der zweiten Seite (20) des optional beschichteten Metallelements (15) mit einem Kontaktierungselement, insbesondere einem Bonddraht, insbesondere einem Kupfer-Bonddraht (33), und/oder einem Bond-Bändchen und/oder einem Kupfer-Clip.

15. Verfahren zum Kontaktieren eines Halbleiterelements (32), insbesondere Leistungsbauelements, mittels eines Substratadapters (27'),
umfassend die Schritte:
- Herstellen eines Substratadapters (27) mit einem Verfahren nach Anspruch 2 oder
nach einem der Ansprüche 3-11 gemäß der von Anspruch 2 abhängigen Alternative oder
nach Anspruch 13 gemäß der von Anspruch 2 abhängigen Alternative;
- Ablösen eines vereinzelten Substratadapters (27'), das das optional beschichtete Metallelement (15) mit zusammengefügtem Kontaktierungsmaterial (13) umfasst, vom Träger (10),
- Positionieren des Substratadapters (27') auf einem Halbleiterelement (32) derart, dass das Kontaktierungsmaterial (13) und das Halbleiterelement (32) zueinander weisen,
- Anheften des Substratadapters (27') auf dem Halbleiterelement (32) durch Wärme- und/oder Druckbeaufschlagung,
- Kontaktieren der zweiten Seite (20) des optional beschichteten Metallelements (15) mit einem Kontaktierungselement, insbesondere einem Bonddraht, insbesondere einem Kupfer-Bonddraht (33), und/oder einem Bond-Bändchen und/oder einem Kupfer-Clip.

## Claims

1. Method of producing a substrate adapter (27), which is used in particular for contacting semiconductor elements (32), comprising the steps:
- application of a contacting material (13) onto one side (12) of a carrier (10),
- structuring of an electrically conducting metal element (15),
- positioning of the structured metal element (15) on the carrier (10) in such a way that a first side (17) of the metal element (15) and the side (12) of the carrier (10) provided with the contacting material (13) are arranged opposite each other,
- joining of the structured metal element (15) with the carrier (10) provided with the contacting material (13),
- application of a transfer element (22) to the second side (20) of the structured metal element (15),
- singulation of the transfer element (22) and/or the structured metal element (15) joined together with the contacting material (13) for further processing.

2. Method of producing a substrate adapter (27'), which is used, in particular for contacting semiconductor elements (32), comprising the following steps:
- application of a contacting material (13) onto one side (12) of a carrier (10),
- structuring of an electrically conducting metal element (15),
- positioning of the structured metal element (15) on the carrier (10) in such a way that a first side (17) of the metal element (15) and the side (12) of the carrier (10) provided with the contacting material (13) are arranged opposite each other,
- joining of the structured metal element (15) with the carrier (10) provided with the contacting material (13),
- singulation of the structured metal element (15) joined together with the contacting material (13) for further processing.

3. Method according to claim 1 or 2
**characterised by**
coating the first side (17) of the structured metal element (15) with a first coating system (25) and/or a second side (20) of the structured metal element (15) with a second coating system (26), more particularly before positioning the structure metal element (15) on the carrier (10).

4. Method according to any one of claims 1 to 3 **characterised in that**
the carrier (10) is a film, in particular a film with adjustable adhesive force, which is clamped in a frame, more particularly a film frame (11), or is wound continuously on a coil carrier.

5. Method according to claim 4
**characterised in that**
the adhesive force between the carrier (10) and the contacting material (13) is smaller than the adhesive force between the contacting material (13) and the structured element (15), so that when the structured metal element (15) is detached from the carrier (10), the contacting material (13) adheres to the structured metal element (15).

6. Method according to any one of claims 1 to 5 **characterised in that**
the contacting material (13) is a sinter material.

7. Method according to any one of the preceding claims **characterised in that**
the contacting material (15) is a solder and/or a conductive adhesive.

8. Method according to any one of the preceding claims **characterised in that**
the contacting material (13) is applied to one side (12) of the carrier (10) with a predetermined structure (14), which, in particular precisely fits the structure (16) of the metal element (15), more particularly of the structured metal element.

9. Method according to any one of claims 3 to 8 **characterised in that**
coating of the first side (17) and/or of the second side (20) of the metal element (15) is carried out by means of galvanisation.

10. Method according to any one of the preceding claims **characterised in that**
during the joining, in particular during pressing, of the metal element (15) with the carrier (10), the metal element (15), in particular the second side (20) of the metal element (15), is heated by means of a heated stamp (21) to a temperature of 60 °C - 100 °C, in particular 70 °C - 90 °C, more especially 80 °C.

11. Method according to claim 10
**characterised in that**
during pressing, a counter support (19) and/or a counterstamp acts on the side (18) of the carrier (10) which preferably has no contacting material (13).

12. Method according to any one of the preceding claims, in particular according to any one of claims 1 or 3 to 11 **characterised in that**
the transfer element (22) is a transfer film, in particular a self-adhesive film with an adhesive coating, preferably a PSA (pressure-sensitive adhesive) adhesive coating.

13. Method according to any one of the preceding claims **characterised in that**
the structured metal element (15) which is joined together with the carrier (10) and/or the contacting material (13) and is optionally coated and optionally provided with the transfer element (22), is singulated, preferably through sawing and/or laser cutting, and/or punching and/or etching and/or water jet cutting.

14. Method of contacting a semiconducting element (32), more particularly a power component, by means of a substrate adapter (27), comprising the steps:
- producing a substrate adapter (27) with a method according to claim 1 or
according to claim 12 or
according to any one of claims 3-11 in accordance with the alternative depending on claim 1 or
according to claims 13 in accordance with the alternative depending on claim 1,
- detaching of a singulated substrate adapter (27), which comprises the optionally coated metal element (15) which is joined together contacting material (13) and the transfer element (22), from the carrier (10),
- positioning of the substrate adapter (27) on a semiconductor element (32) in such a way that the contacting material (13) and the semiconductor element (32) face each other,
- attaching the substrate adapter (27) to the semiconductor element (32) though the application of heat and/or pressure,
- removing the transfer element (22) and exposing of the second side (20) of the optionally coated metal element (15),
- contacting of the second side (20) of the optionally coated metal element (15) with a contacting element, in particular a bonding wire, more particularly a copper bonding wire (33) and/or a bonding ribbon and/or a copper clip.

15. Method of contacting a semiconductor element (32), more particularly a power component, by means of a substrate adapter (27'), comprising the steps:
- producing a substrate adapter (27) with a method according to claim 2 or
according to any one of claims 3-11 in accordance with the alternative depending on claim 2 or
according to claims 13 in accordance with the alternative depending on claim 2,
- detaching of a singulated substrate adapter (27'), which comprises the optionally coated metal element (15) which is joined together contacting material (13) and the transfer element (22), from the carrier (10),
- positioning of the substrate adapter (27') on a semiconductor element (32) in such a way that the contacting material (13) and the semiconductor element (32) face each other,
- attaching the substrate adapter (27') to the semiconductor element (32) though the application of heat and/or pressure,
- contacting of the second side (20) of the optionally coated metal element (15) with a contacting element, in particular a bonding wire, more particularly a copper bonding wire (33) and/or a bonding ribbon and/or a copper clip.

## Revendications

1. Procédé de production d'un adaptateur de substrat (27), qui sert en particulier à l'interconnexion d'éléments semi-conducteurs (32), comprenant les étapes de :
- application d'un matériau d'interconnexion (13) sur un côté (12) d'un support (10),
- structuration d'un élément métallique électro-conducteur (15),
- positionnement de l'élément métallique structuré (15) sur le support (10) de telle manière qu'un premier côté (17) de l'élément métallique (15) et le côté (12) du support (10), doté du matériau d'interconnexion (13) sont disposés opposées,
- assemblage de l'élément métallique structuré (15) avec le support (10) doté du matériau d'interconnexion (13),
- application d'un élément de transfert (22) sur le deuxième côté (20) de l'élément métallique structuré (15),
- isolation de l'élément de transfert (22) et/ou de l'élément métallique (15) structuré et assemblé au matériau d'interconnexion (13) pour traitement ultérieur.

2. Procédé de production d'un adaptateur de substrat (27'), qui sert en particulier d'interconnexion d'éléments semi-conducteurs (32), comprenant les étapes :
- application d'un matériau d'interconnexion (13) sur un côté (12) d'un support (10),
- structuration d'un élément métallique électro-conducteur (15),
- positionnement de l'élément métallique structuré (15) sur le support (10) de telle manière qu'un premier côté (17) de l'élément métallique (15) et le côté (12) du support (10), doté du matériau d'interconnexion (13) sont disposés opposées,
- assemblage de l'élément métallique structuré (15) avec le support (10) doté du matériau d'interconnexion (13),
- isolation de l'élément métallique structuré (15) et assemblé au matériau d'interconnexion (13) pour traitement ultérieur.

3. Procédé selon la revendication 1 ou 2,
**caractérisé par**
l'enduction du premier côté (17) de l'élément métallique structuré (15) avec un premier système d'enduction (25) et/ou d'un deuxième côté (20) de l'élément métallique structuré (15) avec un deuxième système d'enduction (26), en particulier avant le positionnement de l'élément métallique structuré (15) sur le support (10).

4. Procédé selon l'une quelconque des revendications 1 à 3,
**caractérisé en ce que**
le support (10) est une feuille, en particulier une feuille avec une force d'adhérence réglable, qui est tendue dans un cadre, en particulier dans un cadre de film (11), ou est enroulée sans fin sur un support à bobine.

5. Procédé selon la revendication 4,
**caractérisé en ce que**
la force d'adhérence entre le support (10) et le matériau d'interconnexion (13) est plus faible que la force d'adhérence entre le matériau d'interconnexion (13) et l'élément métallique structuré (15) de telle manière que le matériau d'interconnexion (13) adhère à l'élément métallique structuré (15) lors d'un décollement de l'élément métallique structuré (15) du support (10).

6. Procédé selon l'une quelconque des revendications 1 à 5,
**caractérisé en ce que**
le matériau d'interconnexion (13) est un matériau de frittage.

7. Procédé selon l'une quelconque des revendications précédentes,
**caractérisé en ce que**
le matériau d'interconnexion (13) est un matériau de brasage et/ou un adhésif conducteur.

8. Procédé selon l'une quelconque des revendications précédentes,
**caractérisé en ce que**
l'application du matériau d'interconnexion (13) sur un côté (12) du support (10) est exécuté avec une structure prédéterminée (14), qui est en particulier adaptée à la structure (16) de l'élément métallique (15) en particulier de l'élément métallique structuré.

9. Procédé selon l'une quelconque des revendications 3 à 8,
**caractérisé en ce que**
l'enduction du premier côté (17) et/ou du deuxième côté (20) de l'élément métallique (15) est exécutée au moyen de la galvanisation.

10. Procédé selon l'une quelconque des revendications précédentes,
**caractérisé en ce que**
l'élément métallique (15) en particulier le deuxième côté (20) de l'élément métallique (15), est chauffé au moyen d'un tampon chauffé (21), pendant l'assemblage, en particulier pendant une compression, de l'élément métallique (15) avec le support (10) à une température de 60 °C - 100 °C, en particulier de 70 °C - 90 °C, en particulier de 80 °C.

11. Procédé selon la revendication 10,
**caractérisé en ce qu'**
un contre-support (19) et/ou un contre-tampon agit pendant la compression sur le côté (18) du support (10), qui ne comporte de préférence aucun matériau d'interconnexion (13).

12. Procédé selon l'une quelconque des revendications précédentes, en particulier selon l'une quelconque des revendications 1 ou 3 à 11,
**caractérisé en ce que**
l'élément de transfert (22) est une feuille de transfert, en particulier une feuille autocollante avec un revêtement adhésif, de préférence un revêtement adhésif ASP (adhésif sensible à la pression).

13. Procédé selon l'une quelconque des revendications précédentes,
**caractérisé en ce que**
l'élément métallique (15) assemblé avec le support (10) et/ou avec le matériau d'interconnexion (13), structuré, revêtu en option et doté en option d'un élément de transfert (22), est séparé de préférence par sciage et/ou découpe au laser et/ou emboutissage et/ou attaque à l'acide et/ou découpe au jet d'eau.

14. Procédé d'interconnexion d'un élément semi-conducteur (32), en particulier d'un composant de puissance, au moyen d'un adaptateur de substrat (27), comprenant les étapes de :
- fabrication d'un adaptateur de substrat (27) avec un procédé
selon la revendication 1, ou
selon la revendication 12, ou
selon l'une quelconque des revendications 3-11 selon l'autre solution dépendant de la revendication 1, ou selon la revendication 13 selon l'autre solution dépendant de la revendication 1,
- séparation du support (10) d'un adaptateur de substrat (27) isolé, qui comprend l'élément métallique revêtu en option (15) avec le matériau d'interconnexion assemblé (13) et l'élément de transfert (22),
- positionnement de l'adaptateur de substrat (27) sur un élément semi-conducteur (32) de telle manière que le matériau d'interconnexion (13) et l'élément semi-conducteur (32) sont tournés l'un vers l'autre,
- fixation de l'adaptateur de substrat (27) sur l'élément semi-conducteur (32) par application de chaleur et/ou de pression,
- enlèvement de l'élément de transfert (22) et libération du deuxième côté (20) de l'élément métallique revêtu en option (15),
- mise en contact du deuxième côté (20) de l'élément métallique revêtu en option (15) avec un élément d'interconnexion, en particulier d'un fil de liaison, en particulier un fil de liaison en cuivre (33) et/ou une bandelette de liaison et/ou une pince en cuivre.

15. Procédé d'interconnexion d'un élément semi-conducteur (32), en particulier d'un composant de puissance, au moyen d'un adaptateur de substrat (27'), comprenant les étapes de :
- fabrication d'un adaptateur de substrat (27) avec un procédé
selon la revendication 2, ou
selon l'une quelconque des revendications 3-11 selon l'autre solution dépendant de la revendication 2, ou selon la revendication 13 selon l'autre solution dépendant de la revendication 2,
- séparation du support (10) d'un adaptateur de substrat (27') isolé, qui comprend l'élément métallique revêtu en option (15) avec le matériau d'interconnexion assemblé (13),
- positionnement de l'adaptateur de substrat (27') sur un élément semi-conducteur (32) de telle manière que le matériau d'interconnexion (13) et l'élément semi-conducteur (32) sont tournés l'un vers l'autre,
- fixation de l'adaptateur de substrat (27') sur l'élément semi-conducteur (32) par application de chaleur et/ou de pression,
- mise en contact du deuxième côté (20) de l'élément métallique revêtu en option (15) avec un élément d'interconnexion, en particulier d'un fil de liaison, en particulier un fil de liaison en cuivre (33) et/ou une bandelette de liaison et/ou une pince en cuivre.
